Europäisches Patentamt

European Patent Office

Office européen des brevets

(19)

(11) **EP 0 798 857 A2**

(12) **EUROPÄISCHE PATENTANMELDUNG**

(43) Veröffentlichungstag:
**01.10.1997 Patentblatt 1997/40**

(51) Int. Cl.[6]: **H03K 17/0814**, H02M 3/28

(21) Anmeldenummer: 97103882.3

(22) Anmeldetag: **07.03.1997**

(84) Benannte Vertragsstaaten:
**BE DE FR GB IT NL**

(30) Priorität: **25.03.1996 DE 19611707**

(71) Anmelder: **Patent-Treuhand-Gesellschaft
für elektrische Glühlampen mbH
81543 München (DE)**

(72) Erfinder:
- **Osterried, Josef
  85521 Ottobrunn (DE)**
- **Hansmann, Frank
  30890 Barsinghausen (DE)**

(54) **Gleichstromsteller**

(57)     Gleichstromsteller mit einem Entlastungsnetzwerk zur Entlastung unidirektional stromdurchflossener Schalter von ihrer Verlustleistungsbeanspruchung beim Ausschalten, mit mindestens einem stromdurchflossenen Schalter, mindestens einer Freilaufdiode und mindestens einer Speicherdrossel, wobei das Entlastungsnetzwerk zwischen drei Punkten des Gleichstromstellers eingefügt ist. Eine Anschlußelektrode der Speicherdrossel ist mit der Freilaufdiode und dem Schalter verbunden. Das Entlastungsnetzwerk umfaßt lediglich einen Entlastungskondensator, eine Ladedrossel, eine Entlastungsdiode und eine Ladediode.

Fig.4

EP 0 798 857 A2

## Beschreibung

Die Erfindung betrifft einen Gleichstromsteller, insbesondere einen Gleichstromsteller mit einem Entlastungsnetzwerk zur Entlastung unidirektional stromdurchflossener Schalter von ihrer Verlustleistungsbeanspruchung beim Ausschalten gemäß dem Oberbegriff des Anspruchs 1.

Ein derartiger Gleichstromsteller ist aus der DE 26 41 183, siehe insbesondere die dortigen Figuren 7, 8 und 9, bekannt. Hierbei ergibt sich jedoch der Nachteil, daß für die Realisierung derartiger Entlastungsnetzwerke mindestens sechs Bauelemente aufzuwenden sind. Bei diesen Bauelementen handelt es sich gemäß der DE 26 41 183 um mindestens drei Dioden, mindestens zwei Kondensatoren und mindestens eine Spule. Diese Bauelemente verursachen nicht nur Zusatzkosten aufgrund ihres reinen Materialwerts. Darüber hinaus entstehen Kosten dadurch, daß diese Bauelemente in die Schaltung eingesetzt werden müssen.

Derartige Gleichstromsteller werden beispielsweise für den Betrieb von Hochdruckentladungslampen und dergleichen verwendet. Für derartige Massenprodukte sind die aus dem Stand der Technik bekannten Gleichstromsteller mit einem Entlastungsnetzwerk zur Entlastung eines in ihnen vorhandenen Schalters von dessen Verlustleistung beim Ausschalten zu aufwendig, insbesondere zu teuer. Deshalb hat man bisher bei derartigen Massenprodukten auf derartige Entlastungsnetzwerke verzichtet und dafür die Verlustleistung beim Ausschalten in Kauf genommen.

Demgemäß ist es Aufgabe der Erfindung, einen Gleichstromsteller mit einem Entlastungsnetzwerk zur Entlastung des unidirektional stromdurchflossenen Schalters von seiner Verlustleistungsbeanspruchung beim Ausschalten gemäß der eingangs genannten Art zur Verfügung zu stellen, der kostengünstiger hergestellt werden kann.

Diese Aufgabe löst ein Gleichstromsteller gemäß Anspruch 1, da das Entlastungsnetzwerk lediglich vier Bauelemente, insbesondere einen Entlastungskondensator, eine Ladedrossel, eine Entlastungsdiode und eine Ladediode umfaßt. In einer besonders vorteilhaften Weiterbildung ist das Entlastungsnetzwerk derart dimensioniert, daß die Beanspruchung des Sperrschalters mit Sperrspannung um den Faktor 2 bis 7, vorzugsweise um den Faktor 3 bis 5, vermindert wird.

In vorteilhafter Weise läßt sich ein erfindungsgemäßer Gleichstromsteller zum Betrieb einer Hochdruckentladungslampe verwenden.

Unidirektional stromdurchflossene Schalter werden in der Elektrotechnik auf vielen Gebieten eingesetzt. Sie besitzen zwei Hauptstromanschlüsse, nämlich einen Stromeingang E und einen Stromausgang A, sowie einen Steueranschluß, über den sie vom leitenden in den sperrenden Zustand und zurück versetzt werden können. Im leitenden Zustand setzen solche Schalter einem von der Hauptstromelektrode E zur Hauptstromelektrode A fließenden Strom beinahe keinen Widerstand entgegen. Im diesem leitenden Zustand ist infolgedessen die am Schalter liegende Spannung nahezu Null. Umgekehrt setzt der unidirektional stromdurchflossene Schalter einem von der Elektrode E zur Elektrode A fließenden Strom im sperrenden Zustand einen sehr hohen Widerstand entgegen. In diesem sperrenden Zustand ist infolgedessen dieser Strom auch dann nahezu Null, wenn zwischen den Elektroden E und A eine erhebliche Spannung anliegt. Beispiele für derartige elektrische oder elektronische, unidirektional stromdurchflossene Schalter sind abschaltbare Thyristoren, als Schalter betriebene bipolare Transistoren sowie als Schalter betriebene Unipolartransistoren (Feldeffekttransistoren). Aus wirtschaftlichen Gründen ist man bestrebt, die thermische Beanspruchung solcher Schalter möglichst gering zu halten. Beim Übergang vom leitenden in den sperrenden Zustand und umgekehrt erfährt der unidirektional stromdurchflossene Schalter aber ohne zusätzliche Vorkehrungen gleichzeitig eine nennenswerte Strom- und Spannungsbelastung, was während dieses Übergangs erhebliche momentane Verlustleistungen zur Folge hat. Zum anderen ist man daher bestrebt, diese Übergänge vom leitenden in den sperrenden Zustand und umgekehrt außerordentlich rasch vorzunehmen, damit die Verlustenergie je Umschaltvorgang so gering wie möglich wird. Aufgrund der dadurch entstehenden schnellen Spannungs- bzw. Stromänderungen können unerwünschte Funkstörungen vermindert werden. Außerdem ist auch bei hoher Umschaltgeschwindigkeit und damit kurzer Übergangzeit von einem in den anderen Schaltzustand die gleichzeitige Beanspruchung des Schalters mit erheblichen Werten von Strom und Spannung unerwünscht. Dies sowohl wegen der dabei verlorengehenden Nutzenergie als auch wegen der dabei auftretenden elektrischen Beanspruchung der unidirektional stromdurchflossenen Schalter, welche häufig die entscheidende Grenze für deren Belastbarkeit darstellt, dies insbesondere für den Abschaltvorgang des unidirektional stromdurchflossenen Schalters.

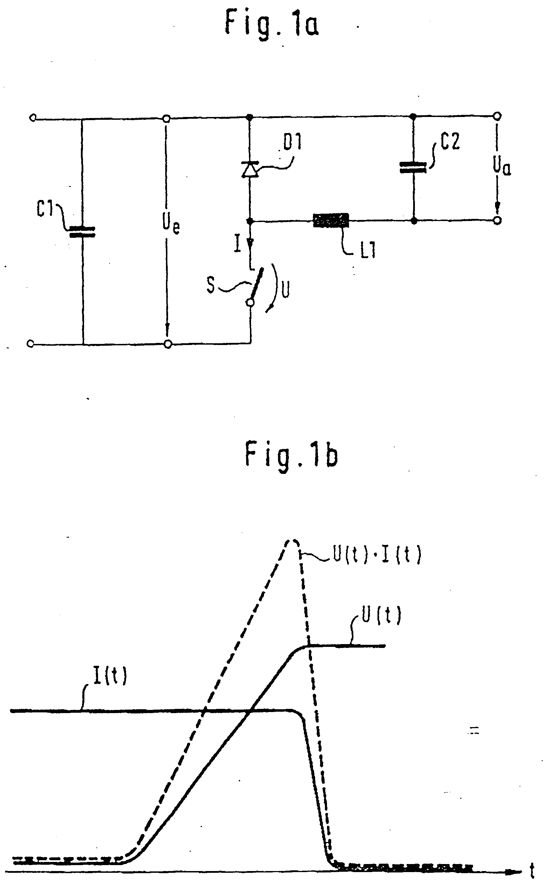

Zur Verdeutlichung dieser Ausführungen ist in Fig. 1a eine bekannte Anordnung für einen Tiefsetzsteller zu sehen, bei der ein unidirektional stromdurchflossener Schalter S aus einem Kondensator C1 gespeist wird. Damit der Strom durch den an den Ausgangsklemmen angeschlossenen Verbraucher auch dann weiterfließen kann, wenn ihm der Weg durch den Schalter S versperrt ist, weil sich dieser im sperrenden Zustand befindet, ist dem Verbraucher eine Freilaufdiode D1 antiparallel geschaltet. Wird der unidirektional stromdurchflossene Schalter in Fig. 1a nun vom leitenden Zustand in den gesperrten Zustand versetzt, so wächst der zwischen den Hauptstromelektroden des Schalters S wirksame Widerstand von einem zunächst sehr geringen auf einen sehr hohen Wert an. Während dieses sehr rasch ablaufenden Vorgangs ändert der Strom aufgrund der Speicherdrossel L1 seine Größe praktisch nicht. Infolgedessen steigt die Spannung zwischen den Hauptstromelektroden des Schalters S von einem zunächst sehr kleinen auf immer höhere Werte an. Erst wenn die Spannung U zwischen den Hauptstromelektroden des Schalters S so groß geworden ist wie die Summe aus Quellenspannung $U_e$ und der Schleusenspannung der Freilaufdiode D1, beginnt der Strom aus der Speicherdrossel L1 über diese Diode D1 zu fließen, und erst wenn dieser Zustand erreicht ist, geht der Strom durch den Schalter S auf einen sehr geringen Wert zurück. Dies geschieht nicht schlagartig, sondern aufgrund stets vorhandener Schaltungsinduktivitäten ebenfalls in einer endlichen Zeitspanne.

Die beschriebenen zeitlichen Verläufe des Stromes I durch den unidirektional stromdurchflossenen Schalter S und der Spannung U zwischen seinen beiden Hauptstromelektroden sind in Fig. 1b dargestellt. Aus den zeitlichen Verläufen U(t) und I(t) bestimmt sich in einfacher Weise das Produkt U (t) * I (t), welches in Fig. 1b ebenfalls dargestellt ist. Man erkennt deutlich die bereits beschriebene hohe Verlustleistungspitze im unidirektional stromdurchflossenen Schalter S beim Abschalten desselben.

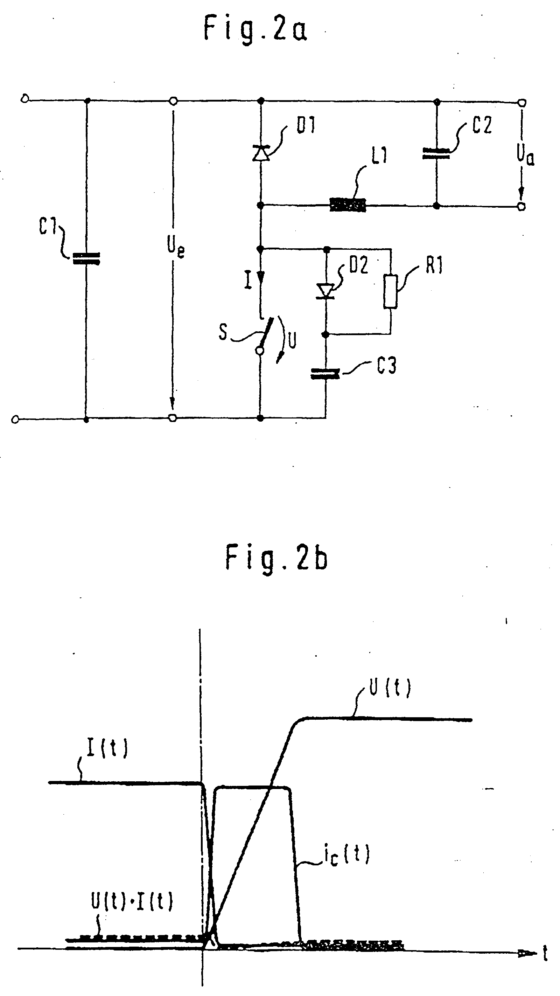

Um diese Verlustleistungsspitze zu verringern, ist es erforderlich, den Strom durch den unidirektional stromdurchflossenen Schalter S bereits auf unschädliche Werte zurückzunehmen, bevor die Spannung zwischen seinen Hauptstromelektroden auf erhebliche Werte angestiegen ist. Eine aus dem Stand der Technik bekannte übliche Methode, mit der dieses Ergebnis erreicht wird, ist in Fig. 2a dargestellt. Hierzu wird zwischen den beiden Hauptstromelektroden des unidirektional stromdurchflossenen Schalters ein Kondensator-Dioden-Nebenweg vorgesehen, welcher beim Ausschalten des Schalters S den bis dahin durch diesen geflossenen Strom übernimmt und die dabei aufgenommene Ladung beim nächsten Einschalten des unidirektional stromdurchflossenen Schalters S über diesen an den zwischengeschalteten Ohmschen Widerstand R1 abgibt.

War in der Anordnung nach Fig. 2a der Schalter S zunächst längere Zeit eingeschaltet und der Kondensator C3 infolgedessen auf die Spannung $U_{C3} = 0$ entladen und wird dann der unidirektional stromdurchflossene Schalter S vom leitenden Zustand in den sperrenden Zustand versetzt, so beginnt der Strom aus der Speicherdrossel L1 auf den durch die Diode D2 und den Kondensator C3 gebildeten Nebenweg überzuwechseln, sobald die Spannung U zwischen den Hauptstromelektroden des Schalters den Wert der Schleusenspannung der Diode D2 erreicht hat. Bei genügend großer Kapazität des Kondensators C3 ist der Strom I durch den Schalter S dann bereits auf unerhebliche Werte abgesunken, bevor die Spannung am Kondensator C3 und damit jene zwischen den Hauptstromelektroden des unidirektional stromdurchflossenen Schalters einen nennenswerten Betrag angenommen hat.

Die zeitlichen Verläufe des Stromes I durch den Schalter S und der Spannung U zwischen seinen beiden Hauptstromelektroden sowie des Stroms $i_C$ durch den Kondensator C3 sind in Fig. 2b dargestellt. Aus den zeitlichen Verläufen U(t) sowie I(t) bestimmt sich in einfacher Weise das Produkt U(t) * I(t), welches in Fig. 2b ebenfalls eingetragen ist. Man erkennt, daß der gewünschte Effekt erreicht wird, d.h. die kritische Verlustleistungspitze beim Ausschalten entfällt.

Entlastungsanordnungen dieser Art weisen jedoch einen gravierenden Nachteil auf. Die dem Kondensator-Dioden-Nebenzweig während des Ausschaltvorgangs zugeführte elektrische Energie wird im Anschluß an das nächste Wiedereinschalten des unidirektional stromdurchflossenen Schalters S zur Vorbereitung der Entlastung beim folgenden Wiederausschalten in Ohmsche Verluste umgesetzt. Bei hohen Umschaltzahlen je Zeiteinheit treten infolgedessen beträchtliche Energieverluste und unerwünschte Erhitzungserscheinungen auf und der von der Umladung des Entlastungskondensators C3 nach dem Wiedereinschalten des Schalters S beanspruchte Ohmsche Widerstand R1 muß für hohe Belastung ausgelegt werden.

Um diesen Nachteil zu vermeiden, wurde in der DE 26 41 183 eine Schaltung gemäß Fig. 3 vorgeschlagen. Diese Schaltung basiert darauf, daß zwischen den genannten Hauptstromelektroden des unidirektional stromdurchflossenen Schalters ein Ausschaltentlastungspfad ausgebildet wird, welcher insgesamt zwei Kondensatoren C3 und C4 enthält und zwischen diesen Kondensatoren durch die Einfügung von in Serie angeordneten Dioden D3 und D4 und einer Ladedrossel L2 Verbindungspfade hergestellt werden. Diese Verbindungspfade führen über den unidirektional stromdurchflossenen Schalter und bewirken, daß im Anschluß an ein auf einen Ausschaltvorgang folgendes Einschalten des unidirektional stromdurchflossenen Schalters eine Umladung der Kondensatoren erfolgt. Diese Umladung erfolgt dergestalt, daß nach Abschluß dieses Umladevorgangs die Kondensatoren so geladen sind, daß der während des folgenden Ausschaltens des unidirektional stromdurchflossenen Schalters in den betroffenen Ausschaltentlastungspfad überwechselnde Strom dort zu Beginn dieses Vorgangs mit Ausnahme von Diodenschleusenspannungen keine resultierende Gesamtgegenspannung vorfindet.

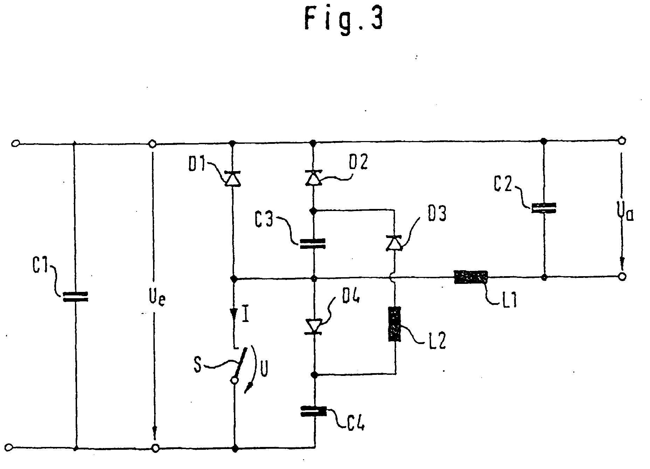

Die vorliegende Erfindung wird anhand der Fign. 1a bis 6 näher erläutert. Davon beschreiben die Fign. 1a bis 3 den Stand der Technik. Die Fign. 4 bis 6 enthalten Ausführungsformen der erfindungsgemäßen Gleichstromsteller.

Im einzelnen stellen dar:

Figur 1a    einen Tiefsetzsteller aus dem Stand der Technik unter Verwendung eines unidirektional stromdurchflossenen Schalters;

Figur 1b    den zeitlichen Verlauf des Stromes I durch den unidirektional stromdurchflossenen Schalters und der Spannung U zwischen seinen Hauptstromelektroden sowie die im Schalter auftretende Verlustleistung U(t) * I(t) für die Anordnung gemäß Fig. 1a;

Figur 2a     einen Tiefsetzsteller mit einem aus dem Stand der Technik bekannten, sogenannten RCD-Entlastungsnetzwerk;

Figur 2b     die Verläufe des Stromes I(t) durch den unidirektional stromdurchflossenen Schalter in Fig. 2a und der Spannung U(t) zwischen dessen Hauptstromelektroden, des Stromes $i_C$ durch den Entlastungskondensator C3 sowie der nunmehr im genannten Schalter auftretenden Verlustleitung U(t) * I(t);

Fig. 3     einen aus dem Stand der Technik bekannten Tiefsetzsteller mit einem Entlastungsnetzwerk, in dem beim Abschalten des unidirektional stromdurchflossenen Schalters nahezu keine Ohmschen Verluste auftreten;

Fig. 4     als erstes Ausführungsbeispiel vorliegender Erfindung einen Tiefsetzsteller mit untenliegendem Schalter S;

Fig. 5     als zweites Ausführungsbeispiel vorliegender Erfindung einen Tiefsetzsteller mit obenliegendem Schalter S;

Fig. 6     als drittes Ausführungsbeispiel vorliegender Erfindung einen Hochsetzsteller.

In den Zeichnungen sind gleiche Elemente mit gleichen Bezugszeichen bezeichnet.

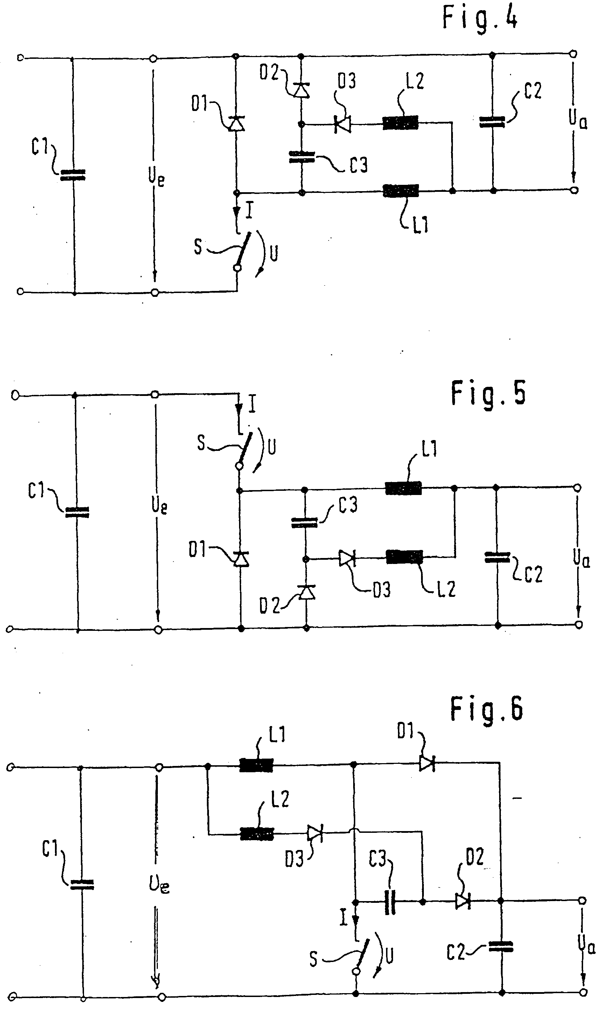

Fig. 4 zeigt einen Tiefsetzsteller mit untenliegendem Schalter S, wobei der Schalter S vom Strom I durchflossen wird und an den Hauptanschlußelektroden des Schalters S die Spannung U abfällt. Der unidirektional stromdurchflossene Schalter S wird gewöhnlich durch einen Thyristor, einen Bipolartransistor oder einen Feldeffekttransistor oder einen IGBT (Isolated Gate Bipolar Transistor) realisiert. Zur Steuerung des Schalters S verfügt der Schalter S über einen nicht dargestellten Steueranschluß. Eingangsseitig liegt am Tiefsetzsteller die Spannung $U_e$, ausgangsseitig die Spannung $U_a$ an, wobei $U_a \leq U_e$ gilt. Die Eingangsspannung $U_e$ wird von einer Spannungsquelle (nicht dargestellt) bereitgestellt. Gemäß einem bevorzugten Anwendungsgebiet für die erfindungsgemäßen Gleichstromsteller kann die Eingangsspannung über einen Gleichrichter aus der Netzspannung gewonnen werden und liegt an einem Kondensator C1 an. Dieser Kondensator C1 ist nicht zwingend nötig und kann durch eine Spannungsquelle ersetzt werden. Die Ausgangsspannung kann in den dargestellten Ausführungsbeispielen an einem Kondensator C2 abgegriffen werden, wobei dieser Kondensator C2 sowohl Bestandteil der erfindungsgemäßen Gleichstromsteller als auch Bestandteil der an den Ausgangsklemmen anzuschließenden Last sein kann. Der Gleichstromsteller umfaßt weiterhin eine Freilaufdiode D1 sowie eine Speicherdrossel L1.

Zur Entlastung des unidirektional stromdurchflossenen Schalters S von seiner Verlustleistungsbeanspruchung beim Ausschalten ist ein Entlastungsnetzwerk, bestehend aus einem Entlastungskondensator C3, einer Entlastungsdiode D2, einer Ladedrossel L2 sowie einer Ladediode D3, zwischen drei Punkte der Gesamtschaltung eingefügt.

Wird in der Gesamtschaltung nach Fig. 4 der unidirektional stromdurchflossene Schalter S nach längerer Einschaltdauer für einige Zeit abgeschaltet, so wird sich der Stromkreis über die Speicherdrossel L1, die Freilaufdiode D1 sowie den Kondensator C2 schließen. Dann ist der Entlastungskondensator C3 nahezu vollständig entladen, die Spannung zwischen seinen Anschlußelektroden also praktisch Null. Wird der Schalter S in Fig. 4 nun vom gesperrten Zustand in den leitenden Zustand versetzt, dann wechselt zum einen der bisher über die Freilaufdiode D1 geflossene Strom der Speicherdrossel wieder auf den Schalter S über und zum anderen lädt sich der Entlastungskondensator C3 über Schalter S, Eingangskondensator C1, Ausgangskondensator C2, Ladedrossel L2 und Ladediode D3 auf die Eingangsspannung auf. Innerhalb der Serienschaltung aus Ladedrossel L2 und Ladediode D3 kann die Reihenfolge getauscht werden. Dabei wird das Zeitintervall für diese Aufladevorgänge in bekannter Weise durch das Produkt aus der Induktivität der Ladedrossel L2 und der Kapazität des Entlastungskondensators C3 festgelegt, während der dabei auftretende Maximalwert des Stroms durch den Entlastungskondensator C3 durch den Quotienten dieser beiden Größen bestimmt wird.

Die in der Ladedrossel L2 gespeicherte Energie wird nach dem Umschwingen des Entlastungskondensators C3 über den Weg Ladedrossel L2, Ladediode D3, Entlastungsdiode D2 und Kondensator C2 wieder abgebaut.

Wird der unidirektional stromdurchflossene Schalter S in Fig. 4 nun wieder vom leitenden Zustand in den sperrenden Zustand versetzt, so wird der Strom aufgrund der Wirkung der Speicherdrossel L1 nahezu unverändert aufrechterhalten. Dieser Strom wechselt nunmehr auf den aus Entlastungskondensator C3 und Entlastungsdiode D2 gebildeten Nebenweg über und beginnt den Entlastungskondensator C3 zu entladen. Die Entladung von C3 findet so lange statt, bis die an der Kombination aus Entlastungskondensator C3 und Entlastungsdiode D2 abfallende Spannung größer als die Schleusenspannung der Freilaufdiode D1 ist. In anderen Worten: Erst wenn durch Umladen des Entlastungskondensators C3 das Potential an der Anode der Freilaufdiode D1 einen Wert erreicht hat, der um die Schleusenspannung der Freilaufdiode D1 höher liegt als das Potential an der Kathode von D1, fließt der Strom durch die Freilaufdiode D1. Bei genügend großer Kapazität des Entlastungskondensators C3 ist der Strom durch den Schalter S bereits auf unerhebliche Werte abgesunken, bevor die Spannung am Entlastungskondensator C3 nennenswert zurückgegangen ist und damit die Spannung zwischen den Hauptstromelektroden des Schalters S einen nennenswerten Betrag angenommen hat.

Damit ist der gewünschte Effekt erreicht, d.h. die kritische Verlustleistungsspitze beim Ausschalten des unidirektional stromdurchflossenen Schalters S entfällt.

Der gesamte Abschalt- und Einschaltvorgang erfolgt bis auf die Durchlaßverluste der Dioden verlustfrei. Eine sinnvolle Dimensionierung bei einem Power-MOS als Schalter S liegt bei etwa 2000 V/μsec. Dies bedeutet eine Dimensionierung des Entlastungskondensators C3 von ca. 0,5 nF pro Ampere zu schaltendem Strom. Bei einer Schaltgeschwindigkeit des unentlasteten Schalters von 10.000 V/μsec wird durch das Entlastungsnetzwerk die Schaltgeschwindigkeit um den Faktor 5 verringert. Hierdurch werden Probleme der Funkstörung erheblich vermindert.

Bei einer praktisch realisierten Schaltung zum Betrieb eines Vorschaltgeräts für eine Video-Projektions-Metallhalogenidlampe von 270 W ließen sich bei einer Schaltfrequenz von 50 kHz und einem zu schaltenden Strom von 18 A (ohne Entlastungsnetzwerk: Anstiegszeit der Drain-Source-Spannung 30 nsec, Abfallzeit des Drainstroms 30 nsec) die Abschaltverluste von 8 W auf weniger als 0,5 W reduzieren.

Für die Dimensionierung des Entlastungsnetzwerks sollte die Zeitdauer, innerhalb der an den Hauptanschlußelektroden des Schalters S die maximale Spannung abfällt, gegenüber den Verhältnissen ohne Entlastungsnetzwerk um den Faktor 2 bis 7, vorzugsweise um den Faktor 3 bis 5, verlängert werden.

Fig. 5 zeigt ein zweites Ausführungsbeispiel vorliegender Erfindung. Hierbei handelt es sich um einen Tiefsetzsteller mit obenliegendem Schalter S. Die prinzipielle Funktionsweise dieser Schaltung entspricht derjenigen, wie sie anhand Fig. 4 ausführlich erklärt wurde. Wird in der Schaltung nach Fig. 5 der unidirektional stromdurchflossene Schalter S nach längerer Einschaltdauer für einige Zeit abgeschaltet, so ist der Entlastungskondensator C3 nahezu vollständig entladen, die Spannungen zwischen seinen Anschlußelektroden also praktisch Null. Wird der Schalter S in Fig. 5 nun vom gesperrten Zustand in den leitenden Zustand versetzt, dann wechselt zum einen der bisher über die Freilaufdiode D1 geflossene Strom der Speicherdrossel L1 wieder auf den Schalter S über. Andererseits lädt sich der Entlastungskondensator C3 über den Weg Ladediode D3, Ladedrossel L2, Kondensator C2, Kondensator C1 und Schalter S auf die Eingangsspannung auf. Wird der unidirektional stromdurchflossene Schalter S nun wieder vom leitenden Zustand in den sperrenden Zustand versetzt, so beginnt der Strom durch die Speicherdrossel L1 auf den der Freilaufdiode D1 parallel geschalteten Nebenweg aus Entlastungskondensator C3 und Entlastungsdiode D2 überzuwechseln. Die Entladung des Entlastungskondensators C3 dauert so lange, bis sich das Potential an der Kathode der Freilaufdiode D1 um deren Schleusenspannung vom Potential an ihrer Anode unterscheidet und die Freilaufdiode D1 somit durchschaltet. Nach dem Umschwingen des Entlastungskondensators C3 erfolgt der Abbau der in der Ladedrossel L2 gespeicherten Energie über den Weg Ladedrossel L2, Kondensator C2, Entlastungsdiode D2 und Ladediode D3. Bei genügend großer Kapazität des Entlastungskondensators C3 ist der Strom durch den Schalter S bereits auf unerhebliche Werte abgesunken, bevor die Spannung am Entlastungskondensator C3 nennenswert zurückgegangen ist und damit die Spannung zwischen den Hauptstromelektroden U des Schalters S einen nennenswerten Betrag angenommen hat.

Auch durch diese Ausführungsform wird das gewünschte Ergebnis, nämlich die Vermeidung von Verlustleistungsspitzen beim Abschalten des Schalters, erreicht.

Ein weiteres in Fig. 6 dargestelltes Ausführungsbeispiel zeigt einen Hochsetzsteller mit eingefügtem Entlastungsnetzwerk, bestehend aus der Ladediode D3, Entlastungsdiode D2, Ladedrossel L2 und Entlastungskondensator C3. Wird der Schalter S nach längerer Einschaltdauer für einige Zeit abgeschaltet, so wird sich der Stromkreis über die Speicherdrossel L1, die Freilaufdiode D1 und den Kondensator C2 schließen. Dann ist der Entlastungskondensator C3 nahezu vollständig entladen, die Spannung zwischen seinen Anschlußelektroden also praktisch Null. Wird nun der Schalter S in Fig. 6 vom gesperrten Zustand in den leitenden Zustand versetzt, dann wechselt zum einen der bisher über die Freilaufdiode D1 geflossene Strom der Speicherdrossel L1 wieder auf den Schalter S über und zum anderen lädt sich der Entlastungskondensator C3 über den Schalter S, den Kondensator C1, die Ladedrossel L2 und die Ladediode D3 auf den doppelten Wert der Eingangsspannung, maximal jedoch auf den Wert der Ausgangsspannung auf. Wird nun der unidirektional stromdurchflossene Schalter S in Fig. 6 wieder vom leitenden Zustand in den sperrenden Zustand versetzt, so beginnt der Strom durch die Speicherdrossel L1 vom Schalter S auf den durch den Entlastungskondensator C3 und die Entlastungsdiode D2 gebildeten Nebenweg überzuwechseln. Bei genügend großer Kapazität des Entlastungskondensators C3 ist auch bei diesem Ausführungsbeispiel der Strom durch den Schalter S bereits auf unerhebliche Werte abgesunken, bevor die Spannung am Entlastungskondensator C3 nennenswert zurückgegangen ist und damit die Spannung zwischen den Hauptstromelektroden des Schalters einen nennenswerten Betrag angenommen hat. Die Umladung des Entlastungskondensators C3 geht so lange vonstatten, bis die Freilaufdiode D1 durchgeschaltet wird. Nach dem Umschwingen des Entlastungskondensators C3 wird die in der Ladedrossel L2 gespeicherte Energie über die Ladediode D3, die Entlastungsdiode D2, den Kondensator C2 und den Kondensator C1 abgebaut.

Damit erfüllen die drei Ausführungsbeispiele vorliegender Erfindung die gewünschte Entlastungsfunktion. Unmittelbar im Anschluß an das Einschalten des unidirektional stromdurchflossenen Schalters wird der jeweilige Entlastungskondensator C3 aufgeladen. Beim nächsten Abschalten des unidirektional stromdurchflossenen Schalters, durch rasche Erhöhung des zwischen seinen Hauptstromelektroden liegenden Widerstands eingeleitet, wird die Spannung zwischen diesen Hauptstromelektroden nur so rasch anwachsen, wie der jeweilige Entlastungskondensator C3 von dem zuvor über den Schalter S fließenden Strom entladen wird. Bei genügend großer Kapazität des Entlastungskondensators C3 ist der Strom durch den Schalter S bereits auf unerhebliche Werte abgesunken, bevor die Spannung zwischen den Hauptstromelektroden des Schalters S einen nennenswerten Betrag angenommen hat. Damit ist erreicht, daR der unidirektional stromdurchflossene Schalter S von seiner Verlustleistungsbeanspruchung beim Abschalten entlastet wird, wobei für die Funktionsfähigkeit der Entlastungsanordnung ein einfaches Entlastungsnetzwerk mit lediglich vier zusätzlichen Bauelementen genügt.

**Patentansprüche**

1. Gleichstromsteller mit einem Entlastungsnetzwerk (C3, L2, D2, D3) zur Entlastung unidirektional stromdurchflossener Schalter (S) von ihrer Verlustleistungsbeanspruchung beim Ausschalten, mit mindestens einem unidirektional Stromdurchflossenen Schalter (S), mindestens einer Freilaufdiode (D1) und mindestens einer Speicherdrossel (L1), wobei das Entlastungsnetzwerk (C3, L2, D2, D3) zwischen drei Punkten des Gleichstromstellers eingefügt ist, wobei eine Anschlußelektrode der Speicherdrossel (L1) mit der Freilaufdiode (D1) und dem Schalter (S) verbunden ist, dadurch gekennzeichnet, daß das Entlastungsnetzwerk einen Entlastungskondensator (C3), eine Ladedrossel (L2), eine Entlastungsdiode (D2) und eine Ladediode (D3) umfaßt,

    wobei eine Anschlußelektrode des Entlastungskondensators (C3) mit der Elektrode des Schalters (S) verbunden ist, die beim Abschalten des über den Schalter (S) fließenden Stroms (I) ihr elektrisches Potential gegenüber dem elektrischen System, in das der Schalter (S) einbezogen ist, erheblich verändert, die andere Anschlußelektrode des Entlastungskondensators (C3) mit der Entlastungsdiode (D2) verbunden ist, die andere Anschlußelektrode der Entlastungsdiode (D2) mit der Freilaufdiode (D1) verbunden ist, die Anschlußelektrode des Entlastungskondensators (C3),

die mit der Entlastungsdiode (D2) verbunden ist, mit der Serienschaltung aus Ladediode (D3) und Ladedrossel (L2) verbunden ist, die andere Anschlußelektrode der Serienschaltung aus Ladediode (D3) und Ladedrossel (L2) mit der Anschlußelektrode der Speicherdrossel (L1) verbunden ist, die nicht mit dem Schalter (S) verbunden ist.

2. Gleichstromsteller nach Anspruch 1, dadurch gekennzeichnet, daß das Entlastungsnetzwerk derart dimensioniert ist, daß die Beanspruchung des Sperrschalters (S) mit Sperrspannung um den Faktor 2 bis 7 vermindert wird.

3. Gleichstromsteller nach Anspruch 1 oder 2, dadurch gekennzeichnet, daß der Schalter (S) ein Bipolartransistor ist.

4. Gleichstromsteller nach Anspruch 1 oder 2, dadurch gekennzeichnet, daß der Schalter (S) ein Feldeffekttransistor ist.

5. Gleichstromsteller nach Anspruch 1 oder 2, dadurch gekennzeichnet, daß der Schalter (S) ein Thyristor ist.

6. Gleichstromsteller nach Anspruch 1 oder 2, dadurch gekennzeichnet, daß der Schalter S ein IGBT (Isolated Gate Bipolar Transistor) ist.

7. Verwendung eines Gleichstromstellers nach einem der vorhergehenden Ansprüche zum Betrieb einer Hochdruckentladungslampe.

EP 0 798 857 A2

# Fig.1a

# Fig.1b

7

# Fig. 2a

# Fig. 2b

# Fig.3

Fig.4

Fig.5

Fig.6